(19) Europäisches Patentamt
European Patent Office
Office européen des brevets

(11) **EP 2 521 894 B1**

(12) **EUROPÄISCHE PATENTSCHRIFT**

(45) Veröffentlichungstag und Bekanntmachung des Hinweises auf die Patenterteilung:
**26.10.2016 Patentblatt 2016/43**

(21) Anmeldenummer: **11784410.0**

(22) Anmeldetag: **12.08.2011**

(51) Int Cl.:
**G01D 5/14** (2006.01)     **G01B 7/14** (2006.01)
**G01R 33/12** (2006.01)

(86) Internationale Anmeldenummer:
**PCT/DE2011/001590**

(87) Internationale Veröffentlichungsnummer:
**WO 2012/022300 (23.02.2012 Gazette 2012/08)**

(54) **VERFAHREN UND VORRICHTUNG ZUR ERFASSUNG VON MAGNETFELDERN**

METHOD AND APPARATUS FOR SENSING MAGNETIC FIELDS

PROCÉDÉ ET DISPOSITIF POUR DÉTECTER DES CHAMPS MAGNÉTIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.08.2010 DE 102010034327**

(43) Veröffentlichungstag der Anmeldung:
**14.11.2012 Patentblatt 2012/46**

(73) Patentinhaber: **Micro-Epsilon Messtechnik GmbH & Co. KG**
**94496 Ortenburg (DE)**

(72) Erfinder:
• **PFAFFINGER, Christian**
**94099 Ruhstorf a. d. Rott (DE)**
• **HOFER, Johann**
**94496 Ortenburg (DE)**
• **MEDNIKOV, Felix**
**94496 Ortenburg (DE)**
• **WISSPEINTNER, Thomas**
**94496 Ortenburg (DE)**
• **SCHALLMOSER, Günter**
**94099 Ruhstorf a. d. Rott (DE)**
• **MEDNIKOV, Vladislav**
**443096 Samara (RU)**

(74) Vertreter: **Patent- und Rechtsanwälte Ullrich & Naumann**
**PartG mbB**
**Schneidmuehlstrasse 21**
**69115 Heidelberg (DE)**

(56) Entgegenhaltungen:
EP-A1- 0 763 832     EP-A1- 1 438 921
EP-A2- 0 989 411     EP-A2- 1 770 361
US-A1- 2005 242 955     US-A1- 2008 164 868

• PHAN ET AL: "Giant magnetoimpedance materials: Fundamentals and applications", PROGRESS IN MATERIALS SCIENCE, Bd. 53, Nr. 2, 1. Februar 2008 (2008-02-01), Seiten 323-420, XP022492050, PERGAMON PRESS, GB ISSN: 0079-6425, DOI: 10.1016/J.PMATSCI.2007.05.003
• VALENZUELA R ET AL: "A position sensor based on magnetoimpedance", JOURNAL OF APPLIED PHYSICS (AIP), Bd. 79, Nr. 8, 15. April 1996 (1996-04-15), Seiten 6549-6551, XP002672002, FORTIETH ANNUAL CONFERENCE ON MAGNETISM AND MAGNETIC MATERIALS 6-9 NOV. 1996 PHILADELPHIA, PA, USA ISSN: 0021-8979

**Beschreibung**

Die Erfindung betrifft ein Verfahren und eine Vorrichtung zur Erfassung von Magnetfeldern, insbesondere zur Positionserfassung von Objekten. Im Konkreten betrifft die Erfindung ein Verfahren zur Erfassung von Magnetfeldern, insbesondere zur Positionserfassung von Objekten, mit einem vorzugsweise länglichen, weichmagnetischen Element, welches mit einer Elektronik verbunden ist, wobei mit der Elektronik die Impedanz des weichmagnetischen Materials gemessen wird. Des Weiteren betrifft die Erfindung eine Vorrichtung zur Erfassung von Magnetfeldern, insbesondere zur Positionserfassung von Objekten, mit einem vorzugsweise länglichen, weichmagnetischen Material, welches mit einer Elektronik verbunden ist, wobei durch die Elektronik die Impedanz (Güte) des weichmagnetischen Materials ermittelt/gemessen wird, insbesondere zur Anwendung des erfindungsgemäßen Verfahrens.

Positionsmessaufgaben sind in zahlreichen Anwendungen zu lösen. In der Automatisierungstechnik ist es erforderlich, die Position von Objekten im Verarbeitungsprozess zu erkennen oder bewegte Maschinenteile zu überwachen. Im Kfz-Bereich wird gerade in Kraftfahrzeugen eine Vielzahl von Bewegungen und Positionen im oder am Motor, Kupplung, Getriebe, Karosserieteile etc. überwacht. Ähnliche Anwendungen gibt es auch aus dem Bereich der Luftfahrt, wo in Flugzeugen die Positionen von Klappen, Türen oder Fahrwerken zu erfassen sind. Auch im Konsumerbereich wird z.B. in Waschmaschinen die Gewichtsmessung der Wäsche über eine Positionsmessung durchgeführt.

Zahlreiche Lösung für diese Positionsmessaufgaben sind dazu in der Literatur beschrieben, die mit unterschiedlichen physikalischen Messmethoden arbeiten, wie zum Beispiel tastende, kapazitive, induktive, optische oder auch magnetische Messverfahren. Eine besondere Klasse dieser Messverfahren sind die magnetischen Verfahren, weil dabei üblicherweise am zu erfassenden Objekt (Messobjekt) ein Magnet angebracht wird. Eine Variante dazu sind Sensoren, wo der Magnet dem Sensor zugeordnet ist und die Rückwirkung durch das Messobjekt erfasst wird. Hier muss das Messobjekt jedoch magnetische Eigenschaften, insbesondere ferromagnetische Eigenschaften aufweisen. Diesen Sensoren gemeinsam ist, dass die Position des Messobjektes durch eine magnetische Rückwirkung erfasst wird, die durch einen Sensor detektiert wird. Besonders geeignet sind magnetische Sensoren dort, wo durch feststehende Körper hindurch die Bewegung von bewegten Objekten detektiert werden muss. Durch die Ausbreitung von Magnetfeldern durch nichtmagnetische Materialien hindurch kann z.B. damit die Position von Kolben innerhalb von Zylindern gemessen werden, sofern dieser aus nichtmagnetischem Material, beispielsweise Aluminium, besteht.

Derartige Positionssensoren mit magnetischem Messprinzip sind lange bekannt.

Es gibt mehrere verschieden Verfahren und Materialien, die verwendet werden können, um die relative Position eines Sensors gegenüber einem Messobjekt mit eingebauten Magneten (Permanentmagnet und Elektromagnet) zu messen. Typische Beispiele umfassen Hall-Sensoren, Magnetoresistive Sensoren (AMR, GMR, XMR), Fluxgate Sensoren.

Aus der DE 196 21 886 A1 ist eine magnetische Positionsmessvorrichtung zur Bestimmung der Relativlage zweier zueinander beweglicher Objekte mit mindestens einem Fluxgate Sensor zur Abtastung einer periodisch magnetisierten Messteilung mit der Teilungsperiode bekannt, wobei der Fluxgate Sensor mindestens eine Erregerspule und mindestens zwei um einen weichmagnetischen Trägerkörper angeordnete Sensorsspulen umfasst, die zueinander im bestimmten Abständen angeordnet sind.

Für große Messbereiche sind mehrere Fluxgate Sensoren mit linearem Trägerkörper parallel zueinander angeordnet und in Dünnfilmtechnik gefertigt.

Es ist auch eine Interpolationseinheit vorgesehen, welche nach dem Prinzip Amplitudenauswertung trägerfrequenter Signale arbeitet.

Aus der DE 10 2007 062 862 A1 ist ein Verfahren zur Bestimmung der Position eines Messobjektes relativ zu einem Sensor bekannt, wobei der Sensor eine mit Wechselstrom beaufschlagte Sensorspule enthält, in dem sich die Permeabilität eines weichmagnetischen Materials unter Einfluss eines Magnetfeldes ändert. Das Magnetfeld wird durch einen Permanentmagneten erzeugt, der dem Messobjekt zugeordnet ist.

Das Dokument XP002672002 ("A position sensor based on magnetoimpedance" von R. Valenzuela et al) beschreibt eine Positionserfassungsvorrichtung, bei dem die elektrisch Impedanz eines weichmagnetischen Drahtes, die von der relativen Lage zu einem Permanentmagneten abhängt, über Anschlüsse am Draht bestimmt wird.

Auf weitere magnetische Sensoren nach dem Stand der Technik wird in der DE 10 2007 062 862 A1 verwiesen.

Die bisher nach dem Stand der Technik bekannten Sensoren haben jedoch Nachteile:

Fluxgate-Sensoren, wie sie nach der DE 196 21 886 A1 verwendet werden, enthalten eine Erreger- und zwei Empfängerspulen, womit die Magnetisierung eines weichmagnetischen Kernes gemessen wird. Auch der Sensor gemäß DE 10 2007 062 862 A1 enthält eine Spule, die mit Wechselstrom gespeist wird. Spulen sind relativ teure Bauteile, da sie aufwändig zu wickeln sind oder - im Falle von auf Leiterplatten gedruckten oder geätzten Spulen - hohe Anforderungen an die Präzision des Druck- oder Ätzprozesses stellen. Ein weiterer Nachteil derartiger Sensoren ist, dass Spulen oder Magnetkerne relativ großvolumige Bauteile darstellen. Somit ist es mit diesen Prinzipien nicht möglich, kleine, kompakte Sensoren zu bauen, die auch in beengten Bauräumen verwendet werden können.

Ein weiterer Nachteil der bekannten Sensoren ist, dass diese primär die Stärke des magnetischen Feldes H messen. Bei den bekannten Hall-Sensoren zum Beispiel gibt es einen direkten linearen Zusammenhang zwischen der Messsignal, nämlich der Hallspannung $U_H$ und dem Magnetfeld H. Auch bei den magnetoresistiven Sensoren ist das primäre Messsignal proportional zum Magnetfeld H. Damit kann mit dieser Gattung Sensoren sehr gut das Magnetfeld gemessen werden. Ein gravierender Nachteil jedoch ist, dass das Magnetfeld eines Permanentmagneten oder Elektromagneten mit der Entfernung vom Magneten nicht linear abfällt, sondern bekanntermaßen eine extrem nichtlineare (häufig exponentielle) fallende Kennlinie besitzt. Somit ist ein Sensor, der zwar eine lineare Kennlinie bezüglich des Magnetfeldes H besitzt, nur bedingt geeignet, die Position eines Messobjektes zu erfassen, das einen Magneten enthält. In der Technik ist es nämlich besonders vorteilhaft, ein Signal zu erhalten, das linear von der gewünschten Größe, in diesem Falle der Position oder dem Abstand des Messobjekts, abhängt, weil dann eine aufwändige Linearisierung oder Kalibrierung entfallen kann. Um bei nichtlinearen Kennlinien trotzdem ein annähernd lineares Signal zu erhalten, wird häufig der Messbereich eingeschränkt, so dass aus der nichtlinearen Kennlinie nur ein kleines, in erster Näherung stückweise lineares Segment verwendet wird. Diese Methode schränkt jedoch den erzielbaren Messbereich drastisch ein.

Der vorliegenden Erfindung liegt nun die Aufgabe zu Grunde, einen einfach aufzubauenden, kostengünstigen und kompakten Sensor mit großem Messbereich und hoher Auflösung für die Messung von Magnetfeldern anzugeben, mit dem die Position von Objekten relativ zum Sensor gemessen werden kann. Letztendlich soll ganz allgemein eine Vorrichtung zur Erfassung von Magnetfeldern mit entsprechenden Eigenschaften angeben werden. Ebenso soll ein entsprechendes Verfahren zur Erfassung von Magnetfeldern angegeben werden, welches die erfindungsgemäße Vorrichtung nutzt.

Voranstehende Aufgabe ist durch die Merkmale der unabhängigen Patentansprüche 1 und 9 gelöst.

Nachfolgend werden das erfindungsgemäße Verfahren und die erfindungsgemäße Vorrichtung gleichermaßen erörtert, nämlich in Bezug auf die erfindungswesentlichen Merkmale.

Das für das neue Sensorprinzip verwendbare weichmagnetische Material kann eine amorphe, nanokristalline oder kristalline Struktur aufweisen und ist in Bandform oder als Mikrodraht mit und ohne Glasisolierung verfügbar. Durch spezielle Materialzusammensetzungen lassen sich verschiedene Grundeigenschaften einstellen

- Magnetostriktion und Magnetoelastische Effekte
- GMI (Giant magneto impedance)

- Magnetische Resonanz

Derartige weichmagnetische Materialien finden in unterschiedlichen Anwendungen Einsatz, wie z.B. bei der Diebstahlsicherung, in Drucksensoren, Kraftsensoren, Wegsensoren, insbesondere auf Basis von Magnetostriktion, etc.

Es gibt verschiedene Methoden zur Herstellung amorpher oder nanokristalliner Mikrodrähte. Beispielsweise wird im Taylor-Ulitovski-Prozess der Mikrodraht direkt aus der Schmelze gezogen. Ein wichtiges Merkmal dieses Prozesses ist es, dass aus reinen Metallen und Legierungen kostengünstig Mikrodrähte mit Durchmessern von ca.1 $\mu$m bis 40 $\mu$m mit Glasisolierung in einem Verfahren herzustellen sind.

Im Prinzip weisen alle weichmagnetischen Materialien eine Abhängigkeit der magnetischen Permeabilität von der auf das Material wirkenden magnetischen Feldstärke auf.

Durch die Verwendung unterschiedlicher Materialkompositionen lassen sich die unterschiedlichen Charakteristiken bezüglich der magnetischen Eigenschaften einstellen. Beispielsweise können die Hysterese, die Form der Hystereseschleife und die maximale Permeabilität dadurch beeinflusst werden.

Besonders vorteilhaft für den erfindungsgemäßen Sensor ist die Verwendung von Materialien, die eine hohe magnetische Permeabilität und eine kleine Koerzitivfeldstärke aufweisen. Dies trifft insbesondere auf Materialzusammensetzungen zu, die den in der Literatur als "MI" (magneto-induktiver) und vor allem mit "GMI" (Giant Magneto-Impedance) bezeichneten Effekt aufweisen.

Der GMI-Effekt verändert ausschließlich den Wechselstromwiderstand (die Impedanz Z) eines magnetischen Materials. Wird ein amorpher oder nanokristalliner Mikrodraht mit Wechselstrom hoher Frequenz gespeist, fließt der Wechselstrom auf Grund des Skin-Effektes überwiegend in einer dünnen Schicht unterhalb der Oberfläche des Drahtes. Die Dicke dieser Schicht wird durch die Skin-Tiefe beschrieben:

$$\delta = \sqrt{\frac{2}{\omega \cdot \sigma \cdot \mu_0 \cdot \mu_r}}$$

mit

$\omega$ : Kreisfrequenz des Wechselstromes

$\sigma$ : Leitfähigkeit

$\mu_r$ : relative Permeabilitätszahl

Wird am Ort des Drahtes ein externes Magnetfeld angelegt, so ändert sich die relative Permeabilität des Drahtes, in dem mit zunehmendem Feld die Permeabilität sinkt. Dadurch erhöht sich die Skin-Tiefe, was dazu führt, dass der Strom auch in tieferen Schichten unterhalb der Drahtoberfläche fließt. Es vergrößert sich also der effektive Drahtquerschnitt, wodurch der Widerstand bzw. die Impedanz Z sinkt.

Die Größe des GMI-Effektes wird in der relativen Impedanzänderung

$$\frac{\Delta Z}{Z} = \frac{Z(H) - Z(H_s)}{Z(H_s)}$$

gemessen, wobei $Z(H)$ die Impedanz beim Magnetfeld $H$ ist und $Z(H_s)$ die Impedanz bei der Sättigungsfeldstärke $H_s$ bedeutet. Die relative Änderung ist besonders groß in dünnen Folien oder Drähten, da die Skin-Tiefe dort im Verhältnis zur Gesamtdicke oder -durchmesser einen großen Anteil hat. Diese relative Änderung kann sehr hohe Werte annehmen, wodurch sehr empfindliche Magnetfeldsensoren hergestellt werden können.

Dieser Effekt kann in Bänder, Folien oder Mikrodrähten aus amorphen und nanokristallinen ferromagnetischen Materialien bei Frequenzen von 0,1 MHz bis 30 MHz beobachtet werden und ist in einer Vielzahl von Veröffentlichungen beschrieben.

Bisher werden Sensoren und Systeme auf Grund des Mikrodrahtes mit magnetoinduktiven Effekt (MI) in Sicherheitssystemen zum Schützen eines Gegenstandes, der ein vorbestimmtes Code-Muster trägt, eingesetzt (z.B. US 5,801,630; US 5,583,333, DE 60003067 T2).

Die vorliegende Erfindung beansprucht ein Verfahren und eine Vorrichtung zum Betreiben eines magnetfeldempfindlichen Positionssensors, bei welchem im Gegensatz zu den bisherig bekannten Sensoren mit beweglichem Magnet oder Elektromagnet ein vergleichsweise großer Messbereich und eine große Auflösung bei gleichzeitig guter Linearität erreicht wird.

Zusätzlich weist die erfindungsgemäße Lösung eine geringe Baugröße, Gewicht und niedrigen Preis auf. Durch diese Eigenschaften ergibt sich ein sehr breites Einsatzgebiet für diese Positionsmessung, z.B. in Waschmaschinen, Kompressoren und Kupplungswegen.

Es gibt nun verschiedene Möglichkeiten, die Lehre der vorliegenden Erfindung in vorteilhafter Weise auszugestalten und weiterzubilden. Dazu ist einerseits auf die den Patentansprüchen 1 und 12 nachgeordneten Patentansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen

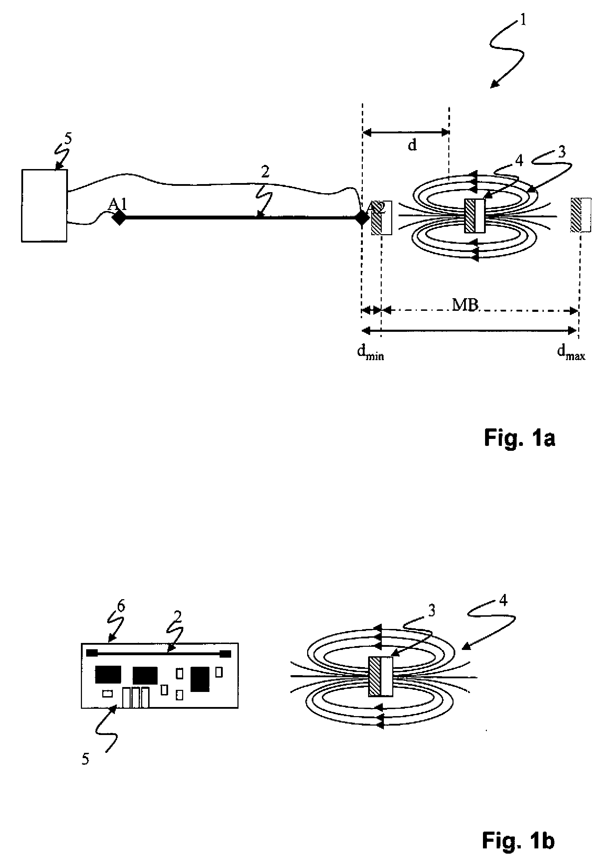

Fig. 1 a in einer schematischen Ansicht ein Ausführungsbeispiel eines erfindungsgemäßen Sensors aus einem langgestreckten, weichmagnetischen Material,

Fig. 1 b in einer schematischen Ansicht ein weiteres Ausführungsbeispiel eines erfindungsgemäßen Sensors, wobei dort ein Grundelement unmittelbar auf Leiterplatten aufgebracht und kontaktiert werden kann,

Fig. 2 in einer schematischen Ansicht ein weiteres Ausführungsbeispiel eines erfindungsgemäßen Sensors, wobei dort ein Magnet relativ zum Grundelement in verschiedenen Orientierungen am Messobjekt angeordnet ist,

Fig. 3 in einem Diagramm die Induktivität und Phase in Abhängigkeit der Feldstärke in axialer Richtung für weichmagnetische Materialien,

Fig. 4 in einem Diagramm die Induktivität und Phase in Abhängigkeit von der Magnetposition, wobei ein linearer Zusammenhang zwischen dem Magnetabstand und der Permeabilität existiert,

Fig. 5 in einem Diagramm die Überlagerung der Funktion $\mu(H)$ der Permeabilität eines weichmagnetischen Materials und H(x) der Abstandsabhängigkeit des Magnetfeldes eines Permanentmagneten,

Fig. 6 in einer schematischen Ansicht eine Testvorrichung, bestehend aus zwei Testspulen, die auf ein Rohr gewickelt sind, welches wiederum über das Grundelement geschoben wird,

Fig. 7 in einer schematischen Ansicht den Arbeitsbereich eines erfindungsgemäßen Sensors, wobei dort der Zusammenhang zwischen $\mu$ und H abgebildet ist,

Fig. 8a in einer schematischen Ansicht die Ausgestaltung des Grundelements als Leiterschleife,

Fig. 8b in einer schematischen Ansicht ein Ausführungsbeispiel eines erfindungsgemäßen weichmagnetischen Elements, eingebaut in ein Röhrchen, z.B. für eine Doppelkupplung,

Fig. 9 in einer schematischen Ansicht ein weiteres Ausführungsbeispiel eines weichmagnetischen Elements in Mäanderform oder als gewickelte Spule,

Fig. 10 in einer schematischen Anordnung ein zweidimensional ausgelegtes Grundelement zur Erfassung der Bewegung in einer Ebene,

Fig. 11 in einer schematischen Ansicht eine serielle Anordnung von Grundelementen, wonach mehrere Grundelemente - seriell - aneinander gereiht sind,

Fig. 12a    in einer schematischen Anordnung eine parallele Anordnung, wobei dort mehrere Grundelemente nebeneinander angeordnet sind, nämlich zur Bildung eines inkrementellen Sensors und

Fig. 12b    in einer schematischen Anordnung eine weitere Variante einer parallelen Anordnung der Grundelemente, wobei dort zwischen mehreren nebeneinander liegenden Grundelementen umgeschaltet werden kann (Multiplexer).

Der erfindungsgemäße Sensor kann aus einem langgestreckten, weichmagnetischen Material bestehen, das an eine Elektronik angeschlossen ist und von einem Wechselstrom durchflossen wird. Dem Messobjekt ist ein Magnet zugeordnet, der in Abhängigkeit von der Position des Messobjektes relativ zum Sensor die Permeabilität in dem weichmagnetischen Material ändert (siehe **Fig. 1a, 1b).**

Durch die Änderung der Permeabilität ändert sich auf Grund des GMI-Effektes die komplexe Impedanz des Schaltkreises, der durch das weichmagnetische Material gebildet wird. Das weichmagnetische Material wird nachfolgend, der Einfachheit halber, als Grundelement bezeichnet. Günstig ist es, die relative Änderung der Impedanz auszuwerten.

Die Auswertung der Impedanz mit bekannten Methoden erlaubt es daher, die Position des Messobjektes relativ zum Sensor zu bestimmen. Beispielsweise kann die Impedanz durch Messung des Spannungsabfalls über den Draht $\frac{\Delta U}{U}$ gemessen werden, wodurch dann auf die Stärke des externen Magnetfeldes und damit auf den Abstand des Messobjektes geschlossen wird.

Man könnte aber auch die Induktivität des Grundelementes auswerten. Als Messsignal dient dann die relative Änderung der Induktivität,

$$\frac{\Delta L}{L} = \frac{L(H) - L(H_s)}{L(H_s)}$$

wobei $L(H)$ die Induktivität beim Magnetfeld $H$ ist und $L(H_s)$ die Induktivität bei der Sättigungsfeldstärke $H_s$ bedeutet. Die Induktivität $L(H)$ ist abhängig vom Magnetfeld $H$ am Ort des Sensors, das wiederum abhängt vom Abstand bzw. der Position des Messobjektes. Damit kann aus der Messung der Induktivität $L$ die Position des Messobjektes bestimmt werden. Die Induktivität kann beispielsweise mit einer Flachspule oder gewickelten Spule abgegriffen werden oder die Rückwirkung auf ein externes Feld mit Hilfe von weiteren Feldsensoren z.B. Hallsensor, AMR, GMR, XMR genutzt werden.

Die Figuren 1a und 1b zeigen im Konkreten ein als Grundelement 2 dienendes weichmagnetisches Material, nämlich gemäß Fig. 1a im Sinne eines länglichen Elements 2. Des Weiteren ist in Fig. 1a neben der Sensoranordnung 1 das Messobjekt 3, der Permanentmagnet 4 und die Auswerteelektronik/Messbrücke 5 gezeigt.

Gemäß Fig. 1b hat das Grundelement 2 einen relativ großen linearen Messbereich und kann, wenn erforderlich, direkt auf Leiterplatten aufgebracht und dort kontaktiert werden. Fig. 1b zeigt neben dem Grundelement 2 das Messobjekt 3, den Permanentmagneten 4, die Auswertelektronik/Messbrücke 5 und die Platine 6, ausgestattet mit Elektronik und dem Grundelement 2

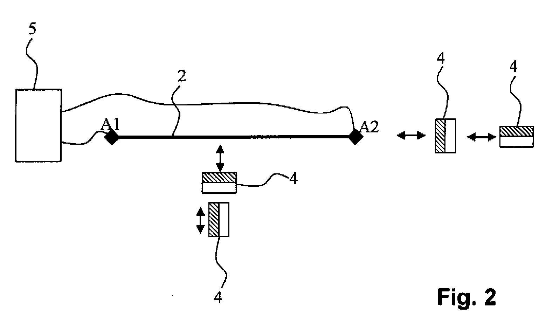

Gemäß der Darstellung in **Fig. 2** kann der Magnet 4 relativ zum Grundelement 2 in verschiedenen Orientierungen am Messobjekt angeordnet sein. Je nach Anforderung der Messaufgabe kann der Magnet 4 so angeordnet sein, dass er sich stirnseitig dem Grundelement 2 annähert oder seitlich dazu. Die Orientierung des Magneten 4 kann dabei so gewählt werden, dass der gewünschte Signalhub im Grundelement 2, abhängig vom Messbereich, erzielt wird. Der Magnet 4 muss dabei nicht unmittelbar mit dem Messobjekt verbunden sein. Vielmehr kann der Magnet 4 auch getrennt vom Messobjekt angeordnet sein, beispielsweise am Sensor. Es ist lediglich sicherzustellen, dass durch das Messobjekt die Feldverteilung des Magneten 4 am Ort des Grundelements 2 verändert wird. Dazu ist es erforderlich, dass das Messobjekt ferromagnetische Eigenschaften hat.

Der Wechselstrom, der durch das Grundelement fließt, kann sinusförmig mit Hilfe eines geeigneten Sinusoszillators erzeugt werden. Aber auch andere Formen der Speisung des Grundelementes wie z. B. mit Rechteck- oder Dreiecksimpulsen, ist möglich. Entscheidend ist lediglich, dass eine zeitabhängige Änderung des Stromes erfolgt, so dass der GMI-Effekt im Grundelement ausgebildet wird. Günstig ist dabei, wenn die Frequenz des Wechselstromes im Bereich von 0,1 ... 40 MHz. liegt.

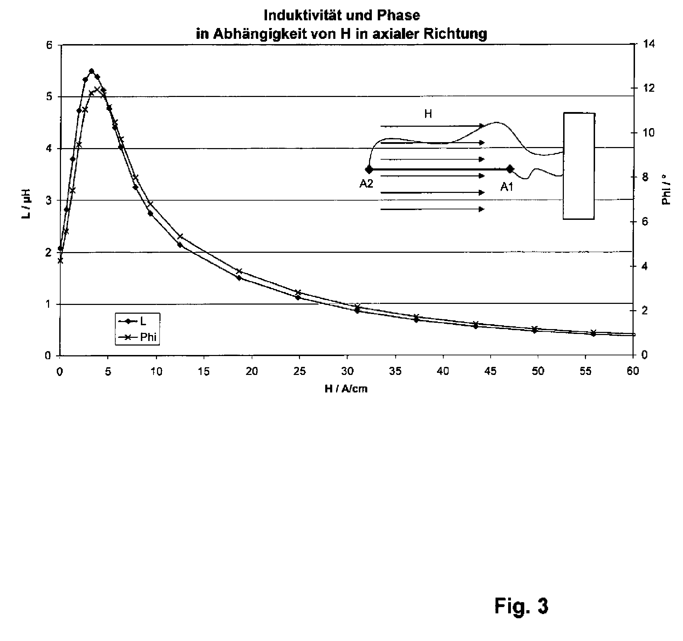

Fig. 3 zeigt die gemessene Induktivität und Phase in Abhängigkeit eines externen Magnetfeldes H. Das Magnetfeld wurde durch eine Helmholtzspule erzeugt und ist am Ort des Grundelementes homogen und in Längsrichtung des Grundelementes orientiert. Die Induktivität wurde mit einer Messbrücke bei einer Frequenz von 1 MHz gemessen.

Für weichmagnetische Materialien hat die magnetische Permeabilität, abhängig von der magnetischen Feldstärke H, eine charakteristische Form. Durch Messung der Induktivität L kann die Permeabilität bestimmt werden, welche in Fig. 3 dargestellt ist. Bekannte magnetfeldempfindliche Sensoren, die zur Feldstärkenmessung verwendet werden, benutzen in der Regel die steigende Flanke der $\mu$(H)-Kurve. Der Grund liegt darin, dass mit derartigen Sensoren vor allem kleine Magnetfelder gemessen werden sollen, wie z. B. das Erdmagnetfeld, oder das Magnetfeld auf magnetischen Datenträgern (Festplatten).

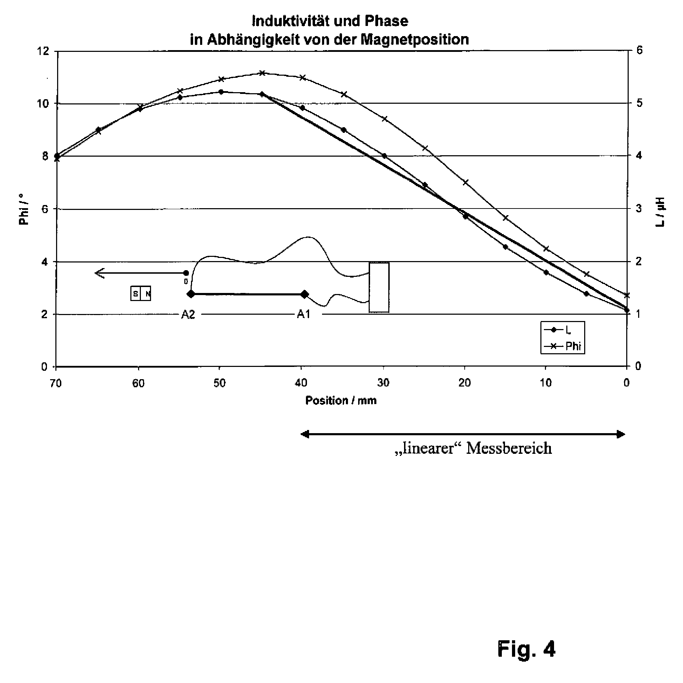

Weiterhin ist erfindungsgemäß erkannt worden, dass für eine Positionsmessung die fallende Flanke günstiger ist, denn es kann ein deutlich größerer Messbereich (bezüglich Positions-/Abstandsmessung zu einem Magneten) erreicht werden. Wie in **Fig. 4** dargestellt, kann ein linearer Zusammenhang zwischen dem Magnetabstand und der Permeabilität erreicht werden. Außerdem zeigt Fig. 4 deutlich, dass der Zusammenhang zwischen $\mu$ und H in hohem Maße nichtlinear ist.

Wie bereits zuvor erwähnt, nimmt auch die magnetische Feldstärke H eines Magneten mit zunehmendem Abstand zur Magnetoberfläche nichtlinear ab.

Fig. 4 zeigt im Konkreten die real gemessene Induktivität eines kurzen Drahtstücks (50 mm) und den gemessenen näherungsweise linearen Bereich der Messung zwischen 0 mm Magnetabstand und ca. 45 mm Magnetabstand.

Bei Vergrößerung des Magnetabstands und somit beim Betreiben des Grundelementes außerhalb des Arbeitsbereiches nimmt das vom Permanentmagneten verursachte Feld weiter ab und führt nach einem weiteren Anstieg zu der beschriebenen Abnahme der magnetischen Permeabilität und somit auch zur Abnahme der gemessenen Induktivität. Die Messung über den weichmagnetischen Draht ist als Faltung der idealisierten Kennlinie in einem Punkt auf einer $\mu$(H)-Kurve mit dem Ort des Magneten zu Interpretieren. Nimmt man die Induktivitätswerte aus der in Fig. 4 gezeigten Kennlinie der fallenden Flanke und vergleicht diese mit den gemäß Fig. 3 entnehmbaren Messungen im homogenen Magnetfeld, so lässt sich der erfindungsgemäß relevante Arbeitsbereich leicht nachvollziehen.

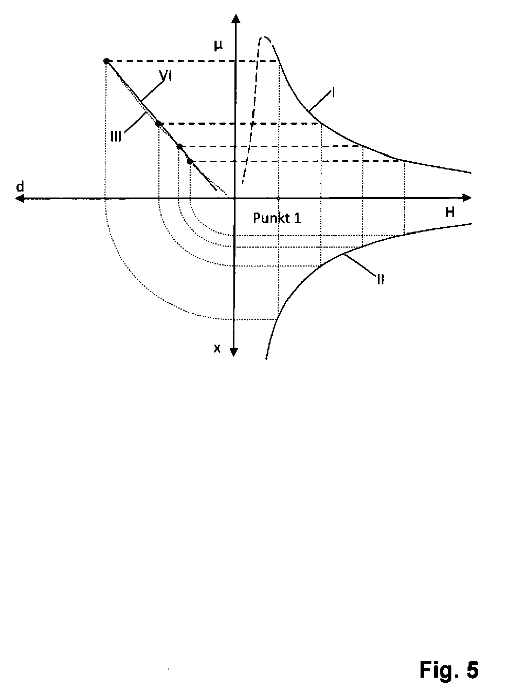

**Fig. 5** zeigt grundsätzlich die Überlagerung der Funktionen $\mu$(H) der Permeabilität eines weichmagnetischen Materials und H(x) der Abstandsabhängigkeit des Magnetfeldes eines Permanentmagneten.

Die beiden nichtlinearen Funktionen überlagern sich im Sensor, wie dies in Fig. 5 beispielhaft gezeigt ist. So besteht die Möglichkeit, einen Sensor zu entwickeln, dessen Ausgangssignal in Abhängigkeit von der Magnetposition in erster Näherung linear ist, ohne zusätzliche Linearisierungsschritte berücksichtigen zu müssen. Die Empfindlichkeit (= Steigung der Kennlinie) und damit verbunden die Auflösung ist über den Messbereich somit nahezu konstant. Dies bietet einen Vorteil gegenüber herkömmlichen magnetischen Positionssensoren. Diese erfordern auf Grund des nichtlinearen Zusammenhangs zwischen Abstand und Permeabilität in Teilbereichen der Kennlinie eine höhere Verstärkung, wodurch auch das Rauschen verstärkt wird und die Auflösung sinkt.

Gemäß der Darstellung in Fig. 5 lässt sich die Linearisierung nachvollziehen. Im Konkreten ist dort gezeigt:

Sektor I: fallende Flanke der $\mu$(H)-Kurve

Sektor II: Abhängigkeit der Feldstärke ($H_=$) eines Permanentmagneten vom Abstand zur Magnetoberfläche

Sektor III: Abhängigkeit $\mu$(d) - Abhängigkeit der magnetischen Permeabilität von Abstand d des Magneten

Sektor IV: linear interpolierte Abhängigkeit $\mu$(d).

Aus Fig. 5. ergibt sich ein relativ linearer Zusammenhang zwischen der Magnetposition und der magnetischen Permeabilität.

Die Induktivität entspricht der Permeabilität des Grundelementes und zeigt den bekannte Kurvenverlauf für weichmagnetische Werkstoffe. Dies entspricht einer idealisierten Darstellung mit homogenem Magnetfeld an jeder Stelle des Grundelementes. In der Realität wird das Magnetfeld jedoch entlang des Grundelementes nicht homogen sein entsprechend der Fig. 5, da das reale Feld eines (Permanent-)Magneten vom Abstand zum Magneten abhängt. Diese idealisierte Kennlinie gilt daher nur für stückweise, infinitesimal kurze Abschnitte des Grundelementes. Insgesamt ergibt sich für die Induktivität des Grundelementes im inhomogenen Feld eine ähnliche Kurve, die im Prinzip der Faltung der Einzelfunktionen entlang der Achse des Grundelementes entspricht.

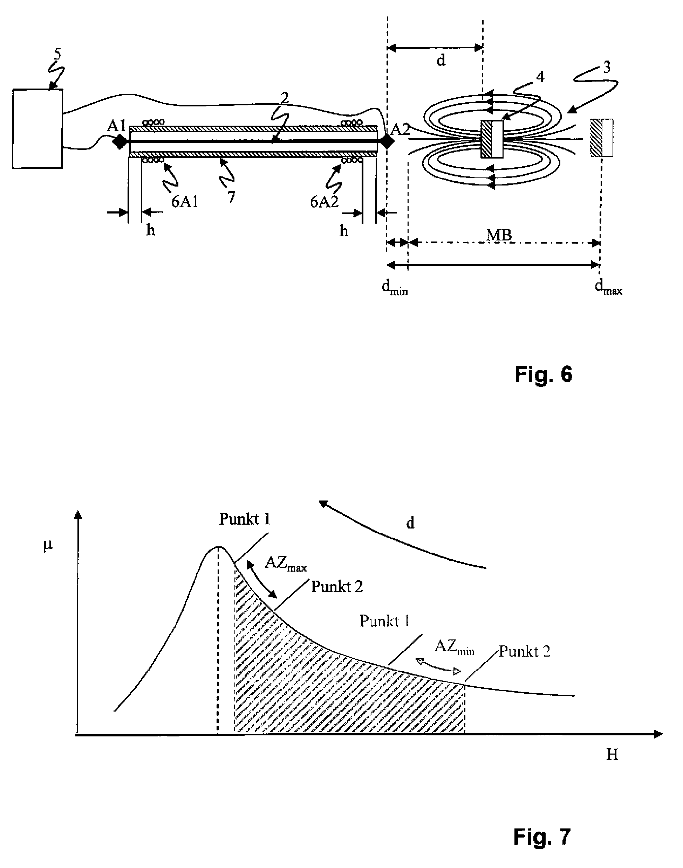

Um sicherzustellen, dass der Arbeitsbereich eines erfindungsgemäßen Sensors auf den fallenden Teil der Kennlinie gemäß Fig. 3 eingestellt wird, kann das Signal mittels einer Testvorrichtung am Grundelement bestimmt werden. Die Testvorrichtung in **Fig. 6** besteht aus zwei Testspulen (6A1 und 6A2), die auf diesem Rohr (7) gewickelt sind, das über das Grundelement geschoben wird. Die Testspulen sind (6) neben den Anschlüssen A1 und A2 des Grundelementes (2) in den Punkten 1 und 2 angeordnet. Um die Messung von Randeffekten auszuschließen, sind die beiden Spulen (6) um den Abstand h beispielsweise um ca. 2-3 mm, gegen die Anschlüsse A1 und A2 verschoben.

**Figur 7** zeigt die Einstellung des Arbeitsbereiches des Sensors.

Um den Arbeitsbereich zu bestimmen, wird das Messobjekt (3) mit einem zunehmenden Abstand d von Anschluss A2 weg axial in Längsrichtung des Grundelementes (2) verschoben. Zunächst befindet sich das Messobjekt nahe am Grundelement. Das Magnetfeld des Permanentmagneten ist am Ort des Grundelementes sehr hoch. Dies entspricht dem sehr flachen Teil der $\mu$(H)-Kurve in Figur 7 bei sehr großer Feldstärke H. Dort ist praktisch keine Änderung von $\mu$ erreichbar, da die Permeabilität des Grundelementes nahezu in Sättigung ist.

Die Induktivitäten der Testspulen (6A1 und 6A2) werden mit einer Messbrücke erfasst. Bei sehr hoher Feldstärke H ist die gemessene Induktivität beider Testspulen gering und nahezu gleich, so dass dieser Bereich für Abstandsmessungen nicht geeignet ist. Der Permanentmagnet wird dann von Anschluss A2 weg mit zunehmendem Abstand solange axial in Längsrichtung des Grundelementes (2) verschoben, bis die Impedanzen der Testspulen 6A1 im Punkt 1 und 6A2 im Punkt 2 sich anfangen zu ändern. Diese Position entspricht dem minimalen Abstand des Magneten und somit der unteren Grenze des Messbereiches und beschreibt die Arbeitszone AZmin.

Der Permanentmagnet wird weiter axial in Längsrichtung des Elementes (2) verschoben bis die gemessene Induktivität der Testspule 6A1 im Punkt 1 einen Maximalwert Lmax erreicht. Dieser Bereich entspricht dem sehr steilen Teil der $\mu$(H)-Kurve in Figur 7 kurz vor Erreichen des Maximums. Diese Position entspricht dem maximalen Abstand des Magneten und somit der oberen Grenze des Messbereiches und beschreibt die Arbeitszone AZmax.

Um sicher zu stellen, dass sich die Arbeitszone AZ auf der fallenden Flanke der $\mu$(H)-Kurve befindet, sollte der Messbereich auf 0.9 Lmax begrenzt werden. Die Bestimmung des Arbeitsbereiches resultiert also darin, dass sich der Permanentmagnet nur innerhalb des dadurch bestimmten Abstandsbereiches auf der fallenden Flanke der $\mu$(H)-Kurve bewegen soll.

Zusätzlich kann dem Wechselstrom, der über das Grundelement fließt, auch ein Gleichstrom überlagert werden. Da der GMI-Effekt ein Wechselstrom-Effekt ist, wird der Gleichstrom nicht durch das externe Magnetfeld beeinflusst.

Mit einer zusätzlichen Speisung des Grundelementes mit Gleichstrom kann ein Signal erzeugt werden, das unabhängig von der Position des Messobjektes nur auf Veränderungen am Grundelement reagiert. Dies können beispielsweise Temperaturänderungen oder elektromagnetische Störungen sein, die den Gleichstromwiderstand des Grundelementes beeinflussen. Mit der Gleichstromspeisung kann also der Einfluss von Störungen detektiert werden. Beispielsweise ändert sich der ohmsche Gleichstromwiderstand des Grundelementes mit der Temperatur. Damit kann durch Messung des Gleichstromwiderstandes sehr einfach eine Temperaturkompensation des Sensors erzielt werden.

In einer anderen vorteilhaften Ausführung kann der Gleichstrom aber auch dazu verwendet werden, ein statisches Magnetfeld zu erzeugen, das in bekannter Weise entlang eines stromdurchflossenen Leiters erzeugt wird. Dieses magnetische Gleichfeld führt dazu, dass sich die Permeabilität des Drahtes ändert. Dies führt sozusagen zu einer magnetischen Vorspannung des Grundelementes, die in einer Verschiebung der Kennlinie resultiert. Diese kann ähnlich dem Verfahren mit der Testspule dazu dienen, den Arbeitsbereich des Sensors einzustellen. Dies ist im Unterschied zum vorher gesagten jedoch eine Voreinstellung, ohne den Abstand des Permanentmagneten zu verändern. Damit kann also auf einfache Weise ein Arbeitsbereich eingestellt werden, ohne den Permanentmagneten selbst oder dessen Position verändern zu müssen. Es ist dadurch möglich, bei vorgegebenen Abständen, die z.B. durch die vorgegebene Bewegungsmöglichkeiten des Messobjektes definiert sind, und ohne dass der Magnet in seiner Orientierung oder Feldstärke extra angepasst werden muss, den Arbeitsbereich so einzustellen, dass der Sensor im optimalen Bereich der fallenden Flanke arbeitet.

Der durch den Draht fließende Gleichstrom kann in vorteilhafter Weise zur Einstellung des Arbeitspunktes auf der Kennlinie verwendet werden. Damit ist es möglich, kleine Felder, wie beispielsweise beim Magnetfeldsensor, oder große Felder, wie beispielsweise beim Positionssensor, zu messen. Folglich lässt sich der Sensor quasi "vorspannen". Durch die Einprägung des Gleichstroms kann je nach Richtung des Stromflusses auch eine Richtungsabhängigkeit erreicht werden. Durch das vom Gleichstrom erzeugte Magnetfeld wird nämlich eine Richtung definiert, da sich das Magnetfeld ringförmig entlang des Drahtes erstreckt. Der durch den Draht fließende Strom kann bei bestimmten Anwendungen eine zusätzliche Kompensationsspule ersetzen, die um den Draht gewickelt werden müsste.

Die Messung der Induktivität des Grundelementes kann, wie bereits beschrieben, auch mittels einer oder mehrerer separater Spulen erfolgen. Dabei kann die Spule auch dazu verwendet werden, am Ort des Grundelementes ein Magnetfeld zu erzeugen, das unabhängig von der Position des externen Magnetfeldes des Permanentmagneten ist. Wenn die Spule mit Gleichstrom durchflossen wird, wird dadurch im Grundelement ein statisches Magnetfeld erzeugt. Dadurch kann ebenfalls eine Vorspannung des Grundelementes erreicht werden. Die erzielbaren Effekte entsprechen dabei dem vorher beschriebenen Verfahren der Gleichstromspeisung des Grundelementes.

Die Ausführung des erfindungsgemäßen Sensors mittels glasisolierten Mikrodrähten ist auch besonders vorteilhaft, weil diese Drähte eine sehr hohe Temperaturbeständigkeit besitzen. Herkömmliche Drähte besitzen beispielsweise eine Isolierung aus Polyurethan, Polyamid oder Polyimid. Diese Isoliermaterialien sind jedoch begrenzt in ihrer Temperaturbeständigkeit. Mit Polyimid isolierte Drähte können beispielsweise bis maximal 250 °C eingesetzt werden. Durch die Verwendung einer Glasisolation, die bei den genannten Mikrodrähten z.B. automatisch auf Grund des Taylor-Ulitovski-Prozesses bereits bei der Herstellung aufgebracht wird, können Sensoren mit einer wesentlich höheren Temperaturbeständigkeit hergestellt werden.

Die Ausführung der Sensoranordnung kann in einer besonders einfachen und kostengünstigen Variante direkt auf ein geeignetes Substrat, wie z.B. eine Leiterplatte oder ein Keramiksubstrat aufgebracht werden (Fig. 1a). Das Grundelement kann mit bekannten Verfahren wie Bonden, Schweißen oder Löten kontaktiert werden. Je nach Länge des Grundelementes ist es zweckmäßig, dieses zwischen den Kontaktstellen zu fixieren, beispielsweise durch Kleben. Die Elektronik kann auf demselben Substrat aufgebracht werden. Dies hat den Vorteil, dass erstens eine besonders kompakte Bauform erzielt wird und zweitens sehr kurze Leitungslängen zwischen Grundelement und Elektronik möglich sind.

Dies ist vorteilhaft, da auf Grund der relativ hohen Frequenzen kurze Leitungslängen wünschenswert sind.

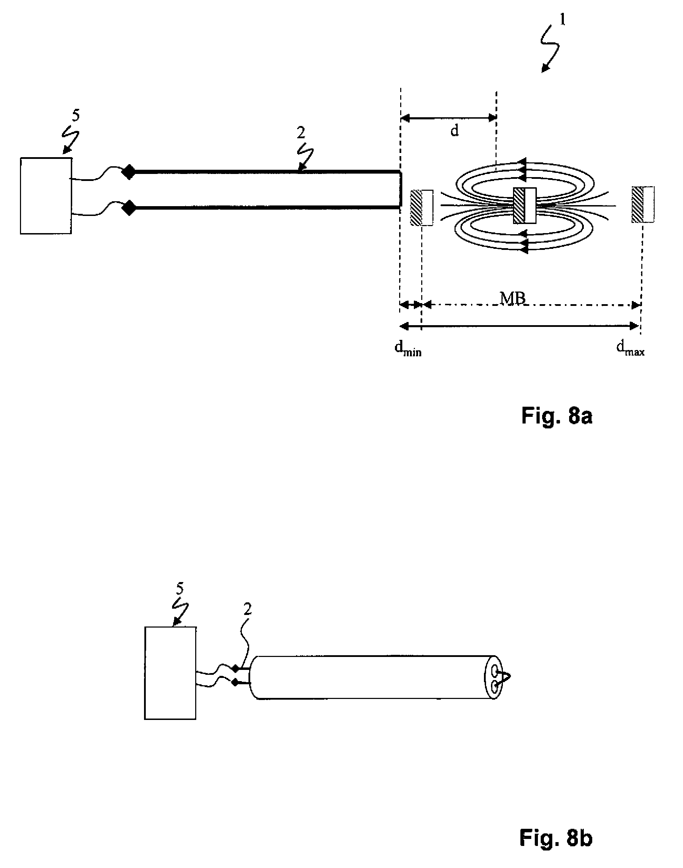

**Fig. 8a** zeigt das Grundelement 2 in Form einer Leiterschleife. Dieses Grundelement 2 eignet sich insbesondere zum Einbau in ein Röhrchen, gemäß der Darstellung in **Fig. 8b,** beispielsweise im Rahmen der Anwendung bei einer Doppelkupplung.

Die Figuren 8a und 8b zeigen neben der Sensoranordnung das Grundelement 2 und die Auswerteelektronik/Messbrücke 5.

Um die Rückleitung zu vermeiden oder die Induktivität zu erhöhen, kann das weichmagnetische Element auch die Funktion der Signalrückleitung erfüllen. Vorteil dieses Ansatzes ist, dass nur eine einseitige Kontaktierung des weichmagnetischen Elementes nötig ist. Ein Einbau in Röhrchen, z.B. bei Doppelkupplungen, ist beispielhaft möglich.

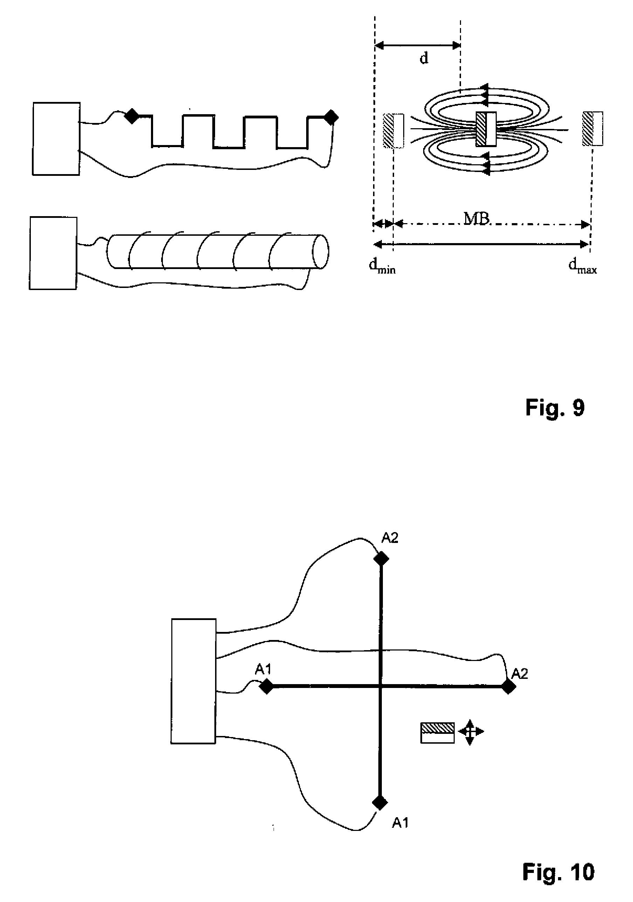

Die Erhöhung der Empfindlichkeit ist beispielsweise auch möglich, indem das Grundelement mäanderförmig oder in Form einer Spule ausgeführt wird (Fig. 9). Durch Erhöhung der Induktivität steigt der Wechselstromwiderstand der Anordnung, wodurch diese auch bei geringeren Frequenzen betrieben werden kann. Dies hat den Vorteil, dass die Elektronik einfacher ausgeführt werden kann und die Empfindlichkeit der Anordnung steigt.

Wenn eine langgestreckte Ausführung aus Gründen der Kontaktierung oder des Bauraumes nicht möglich ist, kann das Grundelement auch in Form einer Schleife ausgebildet werden **(Fig. 9).** Damit ist es möglich, die Kontaktierung des Grundelementes auf einer Seite herzustellen, was die Fertigung erleichtert und den Bauraum verringert. Die Schleife könnte beispielsweise auch innerhalb eines Keramik-Röhrchens ausgeführt werden, womit ein temperaturstabiler, einfacher Sensor mit sehr geringen Abmessungen gefertigt werden kann. Durch die Ausführung in Schleifenform wird gleichzeitig die Induktivität der Anordnung erhöht.

Weitere Anordnungen sind denkbar, in denen das Grundelement frei geformt wird und an spezielle Einbaubedingungen angepasst wird. Bei Verwendung eines Mikrodrahtes kann dieser beispielsweise in nahezu beliebigen Formen entlang von Trajektorien, die das Messobjekt beschreibt, verlegt werden. Denkbar ist z.B. die Ermittlung der Position des Wählhebels von Automatikgetrieben, indem der Draht entlang der abgestuften Positionen des Wählhebels angeordnet wird.

Weiterhin denkbar ist eine Anordnung mehrerer Grundelemente relativ zueinander, um Positionen in zwei oder drei Dimensionen eindeutig zu detektieren **(Fig. 10).** Zweckmäßig ist beispielsweise für die zweidimensionale Erfassung der Bewegung in einer Ebene die Anordnung mehrerer Grundelemente auf einem Substrat unter einem Winkel von 90°. Damit werden zwei Messrichtungen definiert, wodurch eine zweidimensionale Positionserfassung ermöglicht wird. Dies gilt analog auch für drei Dimensionen, indem drei Grundelemente jeweils unter 90° angeordnet werden.

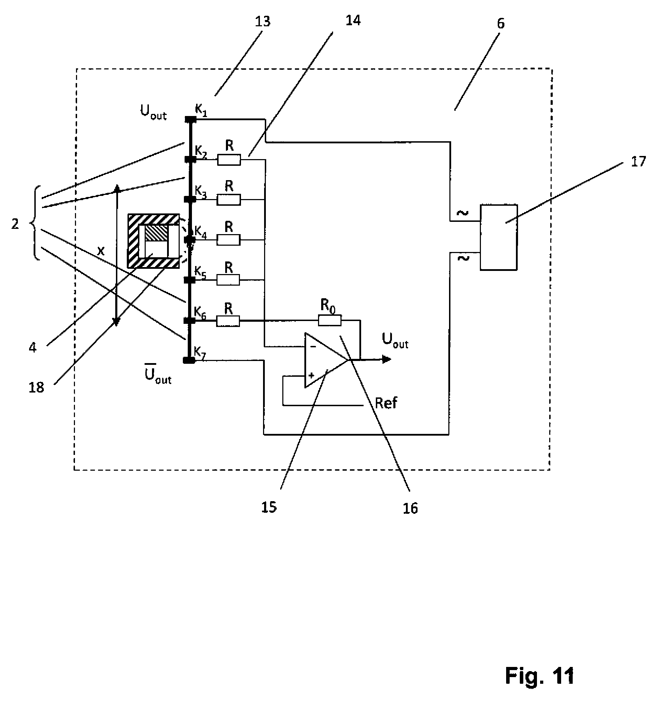

Das Grundelement bietet je nach Anordnung, Feldstärke und Polarisierung des Magneten einen bestimmten Messbereich. Um den Messbereich des erfindungsgemäßen Sensors zu vergrößern, können mehrere Grundelemente entweder seriell oder parallel zueinander angeordnet werden, wobei die einzelnen Elemente dem in Fig. 1 gezeigten Grundelement entsprechen. In einer seriellen Anordnung gemäß **Fig. 11** werden mehrere Grundelemente aneinandergereiht. Durch Spannungsabgriffe wird ein lineares Signal erzeugt, wenn sich der Magnet seitlich entlang der Grundelemente bewegt.

Mehrere Grundelemente sind in einer Reihe über die Kontaktstellen K1 bis K7 miteinander elektrisch verbunden. Auf einem Trägermaterial, beispielsweise einer Leiterplatte oder einem Keramiksubstrat, werden Kontaktstellen K1 bis K7 gebildet, welche einen bestimmten Abstand zueinander aufweisen. Das Messobjekt weist einen Permanentmagneten auf, der in ein Joch eingebaut ist. Das Joch dient zur Feldführung, so dass Feldlinien des Permanentmagneten vorzugsweise nur in Richtung des Sensorelementes wirksam werden. Dabei ist es vorteilhaft, wenn die Feldführung dergestalt wirkt, dass das wirksame Feld näherungsweise dem Abstand benachbarter Kontakte entspricht. Die Kontakte K1 und K7 sind mit den Ausgängen eines Oszillators 6 verbunden. Der Sensor wird vom Oszillator über die Kontaktstellen K1 und K7 mit einem hochfrequenten, komplementären Wechselstrom gespeist. Die Kontakte K2...K6 sind über Widerstände R1...R6 mit dem invertierenden Eingang eines Operationsverstärkers 7 verbunden. Am Ausgang des Operationsverstärkers kann ein Signal abgegriffen werden, das der Position des Messobjektes 2 entlang des Sensors proportional ist. Die Widerstände R könnten beispielsweise lasertrimmbare Widerstände sein, wodurch der Offset und die Nichtlinearität der Kennlinie korrigiert werden kann. Vorteilhaft an dieser Anordnung ist, dass der Sensor komplett auf einer Leiterplatte mit der Auswerteelektronik als eine Einheit ausgeführt werden kann. Die Aneinanderreihung der Grundelemente kann dabei nicht nur als Aneinanderreihung von separaten Grundelementen mit kurzen Drahtstücken erfolgen, sondern es könnte auch ein langes Drahtstück zwischen den Kontakten K1 und K7 angeordnet werden, wobei die Kontaktierung an den Kontaktstellen K2 ... K6 beispielsweise durch Einpressen, Löten oder Schweißen den langen Draht unterteilt, so dass wiederum eine Aneinanderreihung kurzer Grundelemente resultiert.

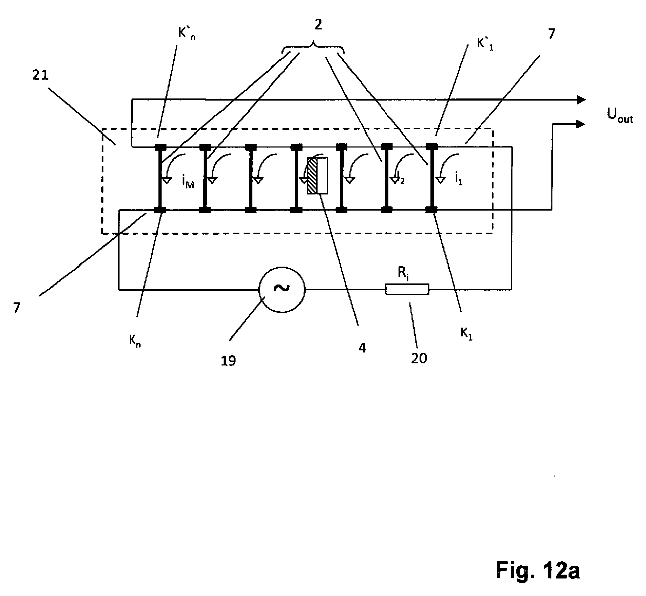

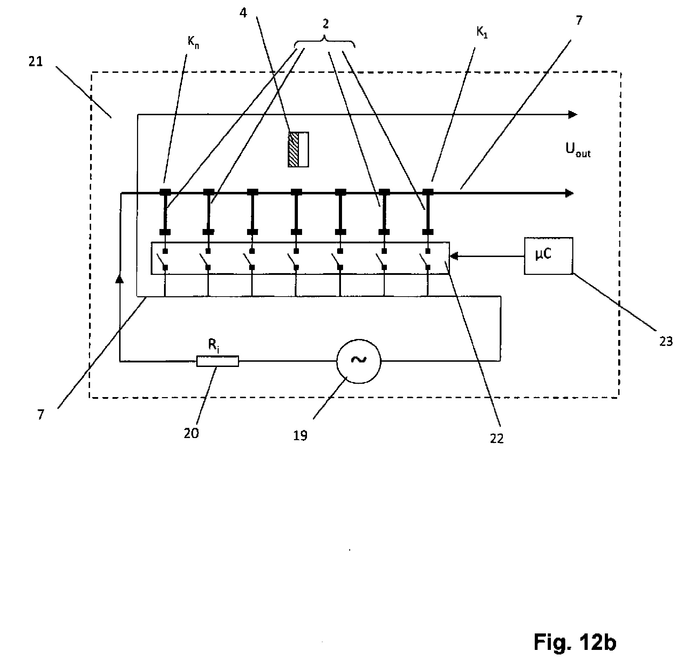

In einer parallelen Anordnung nach **Fig. 12a** werden mehrere Grundelemente nebeneinander angeordnet, wodurch ein inkrementeller Sensor entsteht. Das Signal ist nur noch stückweise eindeutig ähnlich bekannten Inkrementalgebern. In einer Variante der parallelen Anordnung in **Fig. 12b** kann auch zwischen mehreren, nebeneinander liegenden Grundelementen umgeschaltet werden.

Die Fig. 12a, 12b zeigen neben dem Grundelement 1 die Versorgungsleitung 2, das Substrat 3, den Magneten 4 und die Wechselstromquelle 5 mit Innenwi-

derstand $R_0$.

Um die Auflösung eines erfindungsgemäßen Sensors noch weiter zu erhöhen, können mehrere Grundelemente parallel zueinander angeordnet werden. Zwischen zwei parallel auf einem Substrat angeordneten Versorgungsleitungen sind mehrere Grundelemente in gleichem Abstand zueinander parallel angeordnet und an den Kontaktstellen K1 ... Kn mit den Versorgungsleitungen elektrisch verbunden, so dass eine periodische Struktur mit der Periode Delta entsteht. Das Messobjekt bewegt sich parallel zu dem Substrat quer zu den Grundelementen und enthält einen Permanentmagneten. An den Anfangs- und Endkontakten K1' und Kn der Versorgungsleitungen ist eine Wechselstromquelle angeschlossen. Das Ausgangssignal kann an den anderen Enden der Versorgungsleitungen K1 und Kn' abgegriffen werden. Der Vorteil dieser Anordnung ist, dass der Strompfad in den Versorgungsleitungen immer gleich ist und dadurch der Spannungsabfall auf jedem Grundelement entlang des Messbereichs gleich ist. Mit dieser Anordnung kann jedoch nur ein periodisches Ausgangssignal erzielt werden. Damit ist zunächst keine absolute Messung möglich. Eine Absolutmessung könnte jedoch durch bekannte Methoden z.B. durch eine zweite Anordnung erreicht werden, die gegenüber der ersten um eine halbe Periode verschoben ist, oder die nach dem Nonius-Prinzip gegenüber der ersten um eine größere oder kleinere Periode verschoben ist.

Fig. 12b zeigt eine besondere Ausführungsform, wonach die Grundelemente nicht fest zwischen den Versorgungsleitungen kontaktiert sind, sondern wonach jedes Grundelement mit einem Schalter versehen ist. Dieser Schalter ist durch einen Multiplexer gebildet. Im Konkreten sind in Fig. 12b die Grundelement $m_1$ ... $m_n$ dargestellt. Darüber hinaus zeigt Fig. 12b die Versorgungsleitung 2, das Substrat 3, den Permanentmagneten 4, die Wechselstromquelle 5, den Multiplexer 6 und den Microcontroller $\mu$C.

Um den Einfluss von Störfeldern zu reduzieren, ist eine Anordnung nach Fig. 12b besonders vorteilhaft. Ähnlich zur vorhergehenden Figur sind die Grundelemente jedoch nicht fest zwischen den Versorgungsleitungen kontaktiert, sondern jedes Grundelement ist mit einem Schalter versehen. Diese Schalter können beispielsweise durch einen Multiplexer gebildet werden, der von einem Microcontroller angesteuert wird. Sobald das Signal eines Grundelementes eine bestimmte Schwelle erreicht, wird auf das nächste Grundelement umgeschaltet. Der Vorteil dieser Anordnung ist der, dass nur immer dasjenige Grundelement zur Messung verwendet wird, wo sich der Magnet befindet. Störungen, die auf die anderen Grundelemente wirken, gehen daher nicht oder nur in geringem Umfang in das Ausgangssignal ein.

Vorteile der glasbeschichteten Mikrodrähte liegen in einer Kombination von hervorragenden elektromagnetischen Eigenschaften (sehr hohe magnetische Permeabilität, kleine Koerzitivfeldstärke und kleine Wirbelstromverluste) mit guter mechanischer Festigkeit, Flexibilität und Korrosionsbeständigkeit bei gleichzeitig hoher maximal möglicher Einsatztemperatur.

Der Verzicht auf eine zusätzliche Messspule erlaubt eine einfache und kostengünstige Herstellung.

Die bereits im Messeffekt begründete Linearität der Kennlinie erlaubt eine einfache und kostengünstige Auswerteelektronik.

Die bereits im Messeffekt begründete Linearität der Kennlinie verursacht eine hohe Grundempfindlichkeit des Sensors.

Die Verwendung von Mikrodrähten für den erfindungsgemäßen Sensor ermöglicht einen kompakten Sensoraufbau bei geringer Masse.

Durch den sehr kleinen Platzbedarf kann der Mikrodraht direkt in Bauteile integriert werden ohne die mechanischen Eigenschaften des Objektes maßgeblich zu beeinflussen. Ferner ermöglicht die Verwendung des Drahtes eine freie Formgebung.

Durch die Zusammensetzung des verwendeten Microwire-Materials kann die resultierende Kennlinie des erfindungsgemäßen Sensors für die Anwendung optimiert werden.

Hinsichtlich weiterer vorteilhafter Ausgestaltungen der erfindungsgemäßen Vorrichtung wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele der erfindungsgemäßen Vorrichtung, zur Anwendung des erfindungsgemäßen Verfahrens, lediglich zur Erörterung der beanspruchten Lehre dienen, diese jedoch nicht auf die Ausführungsbeispiele einschränken.

**Bezugszeichenliste**

Fig. 1a     1: Sensoranordnung
           2: weichmagnetisches, längliches Element
           3: Messobjekt
           4: Permanentmagnet
           5:   Auswerteelektronik/Messbrücke

Fig. 1b     2: Grundelement
           3: Messobjekt
           4: Permanentmagnet
           5: Auswerteelektronik/ Messbrücke
           6: Platine mit Elektronik und Grundelement.

Fig. 2     2: Grundelement
           4: Permanentmagnet
           5: Auswerteelektronik/ Messbrücke

Fig. 3     Magnetfeld H
           magnetische Feldstärke H
           Induktivität L

Fig. 4    Feldstärke H

Fig. 5    Sektor I: fallende Flanke der μ(H)-Kurve
Sektor II:    Abhängigkeit der Feldstärke (H=) eines Permanentmagneten vom Abstand zur Magnetoberfläche
Sektor III: Abhängigkeit μ(d) - Abhängigkeit der magnetischen Permeabilität von Abstand d des Magneten
Sektor IV: linear interpolierte Abhängigkeit μ(d).
Funktionen μ(H)
H(x)
Sektor I: fallende Flanke der μ(H)-Kurve
Sektor II: Abhängigkeit der Feldstärke (H=) eines Permanentmagneten vom Abstand zur Magnetoberfläche x
Sektor III: Abhängigkeit μ(d) - Abhängigkeit der magnetischen Permeabilität von Abstand des Magneten
Sektor IV: linear interpolierte Abhängigkeit μ(d).

Fig. 6    zwei Testspulen, Spulen 6, 6A1 und 6A2
Rohr 7
Anschlüssen A1 und A2
Grundelement, Element 2
Abstand h
Messobjekt 3
Arbeitszone AZ, AZmin, AZmax
Maximalwert Lmax

Fig. 7    -

Fig. 8a:    1: Sensoranordnung
2: Grundelement
5: Auswerteelektronik/ Messbrücke.

Fig. 8b:    2: Grundelement
5: Auswerteelektronik/ Messbrücke

Fig. 9:    -

Fig. 10:    -

Fig. 11:    2: Grundelemente
4: Permanentmagnet
6: Platine mit Elektronik und Grundelement
13: Kontaktstellen K1...K7
14: Widerstände R
15: Operationsverstärker
16: Widerstand R0
17: Oszillator
18: Joch

Fig. 12a:    2: Grundelemente
4: Permanentmagnet
7: Zuleitung zu den Grundelementen

13: Kontaktstellen K1...Kn
19: Wechselstromquelle
20: Innenwiderstand Ri
21: Substrat

Fig. 12b    2: Grundelemente
4: Permanentmagnet
7: Zuleitungen zu den Grundelementen
13: Kontaktstellen K1... Kn
19: Wechselstromquelle
20: Innenwiderstand Ri
21: Substrat
22: Multiplexer
23: Microcontroller

**Patentansprüche**

1.    Verfahren zur Erfassung von Magnetfeldern, insbesondere zur Positionserfassung von Objekten, mit einem vorzugsweise länglichen, weichmagnetischen Element (2), welches mit einer Elektronik (5) verbunden ist, wobei mit der Elektronik (5) die Impedanz des weichmagnetischen Materials des weichmagnetischen Elements (2) gemessen wird, wobei ein Magnetfeld genutzt wird, indem sich durch die Position eines Objektes (3), das sich in Anordnung zum weichmagnetischen Material befindet, das Magnetfeld am Ort des weichmagnetischen Materials einstellt, wodurch sich die magnetische Permeabilität (μ) des weichmagnetischen Materials sowie dessen Impedanz in Abhängigkeit vom Magnetfeld und somit von der Position des Objektes (3) einstellt,
**dadurch gekennzeichnet, dass**
der Arbeitsbereich (AZ) des weichmagnetischen Elements (2) in der Kurve, in der die magnetische Permeabilität (μ) des Materials des weichmagnetischen Elements (2) über die magnetische Feldstärke (H) aufgetragen ist, auf einen Bereich gelegt ist, in dem die Permeabilität (μ) mit betragsmäßig ansteigender magnetischer Feldstärke (H) kontinuierlich abfällt, dergestalt, dass im Arbeitsbereich (AZ) die Nichtlinearität der Kurve der magnetischen Permeabilität (μ) des Materials des weichmagnetischen Elements (2) in Abhängigkeit von der magnetischen Feldstärke (H) und die Nichtlinearität der Kurve der magnetischen Feldstärke (H) in Abhängigkeit vom Abstand des Objektes (3) zum weichmagnetischen Material des weichmagnetischen Elements (2) sich so kompensieren, dass ein im Wesentlichen linearer Zusammenhang zwischen Abstand und Impedanz entsteht.

2.    Verfahren nach Anspruch 1, **dadurch gekennzeichnet, dass** durch die Änderung der magnetischen Permeabilität eine relative Position eines Messobjektes (3) gegenüber dem länglichen Element (2) ermittelt wird, wobei das Messobjekt (3) einen Permanentmagnet oder einen Elektromagnet (4) umfasst und wobei die Verteilung des magnetisches Feldes entlang des Elementes (2) berücksichtigt ist.

3. Verfahren nach Anspruch 1 oder 2, **dadurch gekennzeichnet, dass** das Magnetfeld aus einem Magnet, einem Permanentmagneten und/oder einem Elektromagneten resultiert.

4. Verfahren nach einem der Ansprüche 1 bis 3, **dadurch gekennzeichnet, dass** dem weichmagnetischen Material ein Permanent- oder Elektromagnet fest zugeordnet ist, und das Objekt aus ferromagnetischen Material besteht.

5. Verfahren nach einem der Ansprüche 1 bis 4, **dadurch gekennzeichnet, dass** sich die Arbeitszone (AZ) des länglichen, weichmagnetischen Elements (2) bei verschiedenen relativen Positionen des Messobjekts (3) gegenüber dem länglichen, weichmagnetischen Element (2) an der fallenden Flanke der $\mu(H)$-Kurve zwischen Punkten 1 und 2 befindet, wobei auf der Kennlinie $\mu(H)$ der Punkt 1 der magnetischen Permeabilität ($\mu$) dem Anschluss A1 und der Punkt 2 der magnetischen Permeabilität ($\mu$) dem Anschluss A2 des Elements (2) entspricht, wobei die Anschlüsse (A1, A2) zum Anschluss des weichmagnetischen, länglichen Elements (2) an die Elektronik (5) ausgebildet sind und die Anschlüsse (A1, A2) jeweils endseitig an den beiden Enden des länglichen, weichmagnetischen Elements (2) angeordnet sind.

6. Verfahren nach einem der Ansprüche 1 bis 5, **dadurch gekennzeichnet, dass** diese Verteilung des magnetisches Feldes entlang des Elementes (2) mit mindestens einer Testspule (6) gemessen wird, wobei die Länge der Testspule (6) kürzer als die Länge des Elementes (2) ist.

7. Verfahren nach einem der Ansprüche 1 bis 6, **gekennzeichnet durch** weitere Verfahrensschritte:

- eine Testvorrichtung wird vorbereitet, welche ein längliches Element (2) aus weichmagnetischem Material mit zwei Anschlüssen A1 und A2, welche auf einem Träger platziert und in einem Rohr (7) eingeschoben ist und einen Permanentmagneten (4) aufweist, mit zwei Testspulen (6A1 und 6A2), die auf diesem Rohr (7) gewickelt sind und wobei die Testspulen (6) neben den Anschlüssen A1 und A2 des Elementes (2) angeordnet sind. Um die Messung von Randeffekten auszuschließen sind die beiden Spulen (6) um den Abstand h gegen die Anschlüsse A1 und A2 verschoben; das Messobjekt (3) wird mit einem Abstand d von Anschluss A2 weg axial in Längsrichtung des Elementes (2) verschoben;
- die Induktivitäten der Testspulen (6A1 und 6A2) werden mit einer Messbrücke erfasst;
- der Permanentmagnet wird von Anschluss A2 weg solange axial in Längsrichtung des Elementes (2) verschoben, bis die Impedanzen der Testspulen 6A1 und 6A2 sich anfangen zu ändern; diese Position entspricht dem minimalen Abstand des Magneten und somit der unteren Grenze des Messbereiches und beschreibt die Arbeitszone $AZ_{min}$;
- der Permanentmagnet wird weiter axial in Längsrichtung des Elementes (2) verschoben, bis die gemessene Induktivität der Testspule 6A1 einen Maximalwert $L_{max}$ erreicht; diese Position entspricht dem maximalen Abstand des Magneten und somit der oberen Grenze des Messbereiches und beschreibt die Arbeitszone $AZ_{max}$.;
- um sicherzustellen, dass sich die Arbeitszone AZ auf der fallenden Flanke der $\mu(H)$-Kurve befindet, wird der Messbereich auf $0.9 * L_{max}$ begrenzt;
- nach dem Feststellen der Arbeitszone bei bestimmtem Messobjekt und bestimmter Elementparameter kann nun die Testvorrichtung entfernt werden und der Sensor ist somit einsetzbar.

8. Verfahren nach Anspruch 1, **dadurch gekennzeichnet, dass** das Element gleichzeitig mit dem Wechselstrom und mit Gleichstrom gespeist wird.

9. Vorrichtung zur Erfassung von Magnetfeldern, insbesondere zur Positionserfassung von Objekten, mit einem vorzugsweise länglichen, weichmagnetischen Element (2), welches mit einer Elektronik (5) verbunden ist, wobei durch die Elektronik die Impedanz des weichmagnetischen Materials des weichmagnetischen Elements (2) gemessen wird, insbesondere zur Anwendung eines Verfahrens nach einem der Ansprüche 1 bis 8, wobei ein Magnetfeld genutzt wird, wobei sich durch die Position eines Messobjekts (3), das sich in Anordnung zum weichmagnetischen Material befindet, das Magnetfeld am Ort des weichmagnetischen Materials einstellt, wobei sich die Permeabilität ($\mu$) des weichmagnetischen Materials in Abhängigkeit vom Magnetfeld und somit in Abhängigkeit von der Position einstellt/ergibt und wobei die Permeabilität ($\mu$), die daraus resultierende, messbare Impedanz ändert, **dadurch gekennzeichnet, dass** der Arbeitsbereich (AZ) des weichmagnetischen Elements (2) in der Kurve, in der die magnetische Permeabilität ($\mu$) des Materials des weichmagnetischen Elements (2) über die magnetische Feldstärke (H) aufgetragen ist, auf einen Bereich gelegt ist, in dem die Permeabilität (μ) mit betragsmäßig ansteigender magnetischer Feldstärke (H) kontinuierlich abfällt, dergestalt, dass im Arbeitsbereich (AZ) die Nichtlinearität der Kurve der magnetischen Permeabilität (μ) des Materials des weichmagnetischen Elements (2) in Abhängigkeit von der magnetischen Feldstärke (H) und die Nichtlinearität der Kurve der magnetischen Feldstärke (H) in Abhängigkeit vom Abstand des Objektes (3) zum weichmagnetischen Material des weichmagnetischen Elements (2) sich so kompensieren, dass ein im Wesentlichen linearer Zusammenhang zwischen Abstand und Impedanz entsteht.

10. Anordnung nach Anspruch 9, **dadurch gekennzeichnet, dass** das Magnetfeld aus einem Magneten, einem Permanentmagneten und/oder einem Elektromagneten resultiert, wobei
sich das Messobjekt relativ zum weichmagnetischen Material bewegen kann, wobei das Magnetfeld am Ort des weichmagnetischen Materials durch die Bewegung des Messobjekts geändert werden kann, wobei sich die Impedanz in Abhängigkeit vom Magnetfeld und damit vom Abstand ändern kann, nämlich aufgrund der Bewegung des Messobjekts.

11. Anordnung nach Anspruch 9 oder 10, **dadurch gekennzeichnet, dass** das weichmagnetische Material amorphes, nanokristallines oder kristallines Material ist und/oder
dass eine längliche Folie oder ein Band oder ein Drahtstück verwendet wird und/oder
dass ein Draht mit Glasisolierung verwendet wird.

12. Anordnung nach einem der Ansprüche 9 bis 11, **dadurch gekennzeichnet, dass** die Speisung mit Wechselstrom oder Wechselspannung erfolgt und/oder
dass eine zusätzliche Speisung mit Gleichstrom vorgesehen ist, um den Arbeitsbereich einzustellen und/oder
dass eine zusätzliche Speisung mit Gleichstrom vorgesehen ist, um eine Temperaturmessung und -kompensation vorzunehmen.

13. Anordnung nach einem der Ansprüche 9 bis 12, **dadurch gekennzeichnet, dass** der Magnet von verschiedenen Seiten angenähert werden kann, vorzugsweise in Richtung oder parallel der Drahtachse und auch quer dazu.

14. Anordnung nach einem der Ansprüche 9 bis 13, **dadurch gekennzeichnet, dass** die Änderung der Impedanz mit einer Testspule an verschiedenen Positionen gemessen wird und/oder
dass die Testspule zur Arbeitsbereicheinstellung mit Gleichstrom versorgt wird und/oder
dass eine Leiterschleife verwendet wird.

15. Anordnung nach einem der Ansprüche 9 bis 14, **dadurch gekennzeichnet, dass** eine Aneinanderreihung von Einzelelementen den Messbereich vergrößert.

## Claims

1. Method for detecting magnetic fields, in particular for detecting the position of objects, using a preferably elongate, soft-magnetic element (2) that is connected to an electronics system (5), the electronics system (5) being used to measure the impedance of the soft-magnetic material of the soft-magnetic element (2), a magnetic field being used by the magnetic field being adjusted at the location of the soft-magnetic material as a result of the position of an object (3) that is arranged relative to the soft-magnetic material, as a result of which the magnetic permeability (μ) of the soft-magnetic material and the impedance thereof is adjusted on the basis of the magnetic field and thus of the position of the object (3),
**characterised in that**, on the curve in which the magnetic permeability (μ) of the material of the soft-magnetic element (2) is plotted against the magnetic field strength (H), the working range (AZ) of the soft-magnetic element (2) is located in a region in which the permeability (μ) continuously decreases as the magnitude of the magnetic field strength (H) increases such that, in the working range (AZ), the non-linearity of the curve for the magnetic permeability (μ) of the material of the soft-magnetic element (2) is compensated for according to the magnetic field strength (H) and the non-linearity of the curve for the magnetic field strength (H) is compensated for according to the distance of the object (3) from the soft-magnetic material of the soft-magnetic element (2) in such a way that a substantially linear relationship is formed between the distance and the impedance.

2. Method according to claim 1, **characterised in that** a relative position of a measured object (3) to the elongate element (2) is determined by changing the magnetic permeability, the measured object (3) comprising a permanent magnet or an electromagnet (4) and the distribution of the magnetic field along the element (2) being taken into consideration.

3. Method according to either claim 1 or claim 2, **characterised in that** the magnetic field results from a magnet, a permanent magnet and/or an electromagnet.

4. Method according to any one of claims 1 to 3, **characterised in that** a permanent magnet or an electromagnet is rigidly associated with the soft-magnetic material, and the object is made of ferromagnetic material.

**5.** Method according to any one of claims 1 to 4, **characterised in that**, when the measured object (3) is in various relative positions to the elongate, soft-magnetic element (2), the working zone (AZ) of the elongate, soft-magnetic element (2) is located on the falling edge of the $\mu$(H) curve between points 1 and 2, point 1 for the magnetic permeability ($\mu$) corresponding to the connection A1 and point 2 for the magnetic permeability ($\mu$) corresponding to the connection A2 of the element (2) on the characteristics curve $\mu$(H), the connections (A1, A2) being designed to connect the soft-magnetic, elongate element (2) to the electronics system (5) and the connections (A1, A2) each being arranged on the end face of each end of the elongate, soft-magnetic element (2).

**6.** Method according to any one of claims 1 to 5, **characterised in that** said distribution of the magnetic field along the element (2) is measured using at least one test coil (6), the length of the test coil (6) being shorter than the length of the element (2).

**7.** Method according to any of claims 1 to 6, **characterised by** additional method steps of:

- preparing a test device which comprises an elongate element (2) that is made of soft-magnetic material, comprises two connections A1 and A2 and is placed on a support and inserted into a tube (7), and a permanent magnet (4), said test device comprising two test coils (6A1 and 6A2) which are wound on said tube (7) and the test coils (6) being arranged next to the connections A1 and A2 of the element (2), the two coils (6) are moved by the distance h towards to the connections A1 and A2 in order to eliminate the measurement of fringe effects, the measured object (3) is axially moved in the longitudinal direction of the element (2) away from connection A2 by a distance d,
- detecting the inductances of the test coils (6A1 and 6A2) using a measuring bridge,
- axially moving the permanent magnet in the longitudinal direction of the element (2) away from connection A2 until the impedances of the test coils 6A1 and 6A2 begin to change; this position corresponds to the minimum distance from the magnet and therefore to the lower limit of the measuring range and denotes the working zone $AZ_{min}$;
- axially moving the permanent magnet further in the longitudinal direction of the element (2) until the measured inductance of the test coil 6A1 reaches a maximum value $L_{max}$; this position corresponds to the maximum distance from the magnet and thus to the upper limit of the measuring range and denotes the working zone $AZ_{max}$;

- in order to ensure that the working zone AZ is on the falling edge of the $\mu$(H) curve, the measuring range is limited to 0.9 * $L_{max}$;
- once the working zone has been set for a specific measured object and a specific element parameter, the test device can be removed and the sensor can therefore be used.

**8.** Method according to claim 1, **characterised in that** the element is supplied with both the AC current and DC current at the same time.

**9.** Device for detecting magnetic fields, in particular for detecting the position of objects, comprising a preferably elongate, soft-magnetic element (2) that is connected to an electronics system (5), the electronics system being used to measure the impedance of the soft-magnetic material of the soft-magnetic element (2), in particular for applying a method according to any one of claims 1 to 8, a magnetic field being used, the magnetic field being adjusted at the location of the soft-magnetic material as a result of the position of a measured object (3) that is arranged relative to the soft-magnetic material, the permeability ($\mu$) of the soft-magnetic material being adjusted/resulting on the basis of the magnetic field and thus of the position of the object, and the permeability ($\mu$) changing the resultant measurable impedance, **characterised in that**, on the curve in which the magnetic permeability ($\mu$) of the material of the soft-magnetic element (2) is plotted against the magnetic field strength (H), the working range (AZ) of the soft-magnetic element (2) is located in a region in which the permeability ($\mu$) continually decreases as the magnitude of the magnetic field strength (H) increases such that, in the working range (AZ), the non-linearity of the curve for the magnetic permeability ($\mu$) of the material of the soft-magnetic element (2) is compensated for according to the magnetic field strength (H) and the non-linearity of the curve for the magnetic field strength (H) is compensated for according to the distance of the object (3) from the soft-magnetic material of the soft-magnetic element (2) in such a way that a substantially linear relationship is formed between the distance and the impedance.

**10.** Arrangement according to claim 9, **characterised in that** the magnetic field results from a magnet, a permanent magnet and/or an electromagnet, the measured object being able to move relative to the soft-magnetic material, it being possible to change the magnetic field at the location of the soft-magnetic material by moving the measured object, the impedance being able to change on the basis of the magnetic field and therefore of the distance, specifically as a result of the movement of the measured object.

**11.** Arrangement according to either claim 9 or claim 10, **characterised in that** the soft-magnetic material is an amorphous, nanocrystalline or crystalline material, and/or **in that** an elongate foil or tape or a piece of wire is used, and/or **in that** a wire insulated by glass is used.

12. Arrangement according to any one of claims 9 to 11, **characterised in that** AC current or AC voltage is supplied and/or **in that** an additional DC current is supplied in order to adjust the working range, and/or **in that** an additional DC current is supplied for the purpose of temperature measurement and compensation.

13. Arrangement according to any one of claims 9 to 12, **characterised in that** the magnet can be approached from different sides, preferably towards or in parallel with the wire axis and also transversely thereto.

14. Arrangement according to any one of claims 9 to 13, **characterised in that** the change in the impedance is measured at different positions using a test coil, and/or **in that** the test coil is supplied with DC voltage in order to adjust the working range, and/or **in that** a conductor loop is used.

15. Arrangement according to any one of claims 9 to 14, **characterised in that** the measurement range is increased by lining up individual elements one behind the other.

**Revendications**

1. Procédé de détection de champs magnétiques, plus particulièrement pour la détection de la position d'objets, avec un élément magnétique doux (2), de préférence oblong, qui est relié avec une électronique (5), l'impédance du matériau magnétique doux de l'élément magnétique doux (2) étant mesurée avec l'électronique (5),
un champ magnétique étant utilisé grâce au fait que la position d'un objet (3), qui se trouve dans une disposition par rapport au matériau magnétique doux, influence le champ magnétique à l'endroit du matériau magnétique doux, ce qui influence la perméabilité magnétique ($\mu$) du matériau magnétique doux ainsi que son impédance, en fonction du champ magnétique et donc de la position de l'objet (3),
**caractérisé en ce que**
la zone de travail (AZ) de l'élément magnétique doux (2) dans la courbe dans laquelle la perméabilité magnétique ($\mu$) du matériau de l'élément magnétique doux (2) est représentée en fonction de l'intensité du champ magnétique (H), est située au niveau d'une zone dans laquelle la perméabilité ($\mu$) diminue de manière continue lorsque l'intensité du champ magnétique (H) augmente, de façon à ce que, dans la zone de travail (AZ), la non-linéarité de la courbe de la perméabilité magnétique ($\mu$) du matériau de l'élément magnétique doux (2) en fonction de l'intensité du champ magnétique (H) et la non-linéarité de la courbe de l'intensité du champ magnétique (H) en fonction de la distance de l'objet (3) par rapport au matériau magnétique doux de l'élément magnétique doux (2) se compensent de façon à ce qu'il en résulte un rapport essentiellement linéaire entre la distance et l'impédance.

2. Procédé selon la revendication 1, **caractérisé en ce que** la variation de la perméabilité magnétique permet de déterminer une position relative d'un objet mesuré (3) par rapport à l'élément oblong (2), l'objet mesuré (3) comprenant un aimant permanent ou un électro-aimant (4) et la répartition du champ magnétique le long de l'élément (2) étant prise en compte.

3. Procédé selon la revendication 1 ou 2, **caractérisé en ce que** le champ magnétique est généré par un aimant, un aimant permanent et/ou un électro-aimant.

4. Procédé selon l'une des revendications 1 à 3, **caractérisé en ce qu'**au matériau magnétique doux correspond un aimant permanent ou un électro-aimant et l'objet est constitué d'un matériau ferromagnétique.

5. Procédé selon l'une des revendications 1 à 4, **caractérisé en ce que** la zone de travail (AZ) de l'élément magnétique doux oblong (2) se trouvent à différentes positions relatives de l'objet mesuré (3) par rapport à l'élément magnétique doux oblong (2) au niveau du flanc descendant de la courbe $\mu(H)$ entre les points 1 et 2, sur la courbe caractéristique $\mu(H)$, le point 1 de la perméabilité magnétique ($\mu$) correspondant au branchement A1 et le point 2 de la perméabilité magnétique ($\mu$) correspondant au branchement A2 de l'élément (2), les raccordements (A1, A2) étant conçus pour le raccordement de l'élément magnétique doux oblong (2) à l'électronique (5) et les branchements (A1, A2) étant disposés au niveau des deux extrémités de l'élément magnétique doux oblong (2).

6. Procédé selon l'une des revendications 1 à 5, **caractérisé en ce que** cette répartition du champ magnétique le long de l'élément (2) est mesurée avec au moins une bobine de test (6), la longueur de la bobine de test (6) étant inférieure à la longueur de l'élément (2).

7. Procédé selon l'une des revendications 1 à 6, **caractérisé par** des étapes de procédé supplémentaires :

- un dispositif de test est préparé, qui comprend un élément oblong (2) en matériau magnétique doux avec deux branchements A1 et A2, qui est placé sur un support et inséré dans un tube (7) et comprend un aimant permanent (4), avec deux bobines de test (6A1, 6A2), qui sont enroulées sur ce tube (7) et les bobines de test (6) étant disposées à proximité des branchements A1 et A2 de l'élément (2) ; pour exclure la mesure d'effets de bord, les deux bobines (6) sont décalées de la distance h contre les branchements A1 et A2 ; l'objet mesuré (3) est éloigné axialement d'une distance d du branchement A2 dans la direction longitudinale de l'élément (2) ;
- les inductances des bobines de test (6A1, 6A2) sont mesurées avec un pont de mesure ;
- l'aimant permanent est éloigné axialement du branchement A2 dans la direction longitudinale de l'élément (2) jusqu'à ce que les impédances des bobines de test 6A1 et 6A2 commencent à varier ; cette position correspond à la distance minimale de l'aimant et donc à la limite inférieure de la zone de mesure et décrit la zone de travail $AZ_{min}$ ;
- l'aimant permanent est éloigné plus loin axialement dans la direction longitudinale de l'élément (2), jusqu'à ce que l'inductance mesurée de la bobine de test 6A1 atteigne la valeur maximale $L_{max}$ ; cette position correspond à la distance maximale de l'aiment et donc à la limite supérieure de la zone de mesure et décrit la zone de travail $AZ_{max}$ ;
- afin de s'assurer que la zone de travail AZ se trouve sur le flanc descendant de la courbe $\mu(H)$, la zone de mesure est limitée à 0,9 * $L_{max}$ ;
- après la définition de la zone de travail pour un objet mesurée déterminé et des paramètres d'éléments déterminés, le dispositif de test peut être retiré et le capteur peut donc être utilisé.

8.  Procédé selon la revendication 1, **caractérisé en ce que** l'élément est simultanément alimenté en courant alternatif et en courant continu.

9.  Dispositif de détection de champs magnétiques, plus particulièrement pour la détection de la position d'objets, avec un élément magnétique doux (2), de préférence oblong, qui est relié à une électronique (5), l'électronique permettant de mesurer l'impédance du matériau magnétique doux de l'élément magnétique doux (2), plus particulièrement pour l'application d'un procédé selon l'une des revendications 1 à 8, un champ magnétique étant utilisé grâce au fait que la position d'un objet (3), qui se trouve dans une disposition par rapport au matériau magnétique doux, influence le champ magnétique à l'endroit du matériau magnétique doux, la perméabilité magnétique

($\mu$) du matériau magnétique doux étant influencée en fonction du champ magnétique et donc de la position et la perméabilité ($\mu$) faisant varier l'impédance mesurable qui en résulte,
**caractérisé en ce que**
la zone de travail (AZ) de l'élément magnétique doux (2) dans la courbe dans laquelle la perméabilité magnétique ($\mu$) du matériau de l'élément magnétique doux (2) est représentée en fonction de l'intensité du champ magnétique (H), est située au niveau d'une zone dans laquelle la perméabilité ($\mu$) diminue de manière continue lorsque l'intensité du champ magnétique (H) augmente, de façon à ce que, dans la zone de travail (AZ), la non-linéarité de la courbe de la perméabilité magnétique ($\mu$) du matériau de l'élément magnétique doux (2) en fonction de l'intensité du champ magnétique (H) et la non-linéarité de la courbe de l'intensité du champ magnétique (H) en fonction de la distance de l'objet (3) par rapport au matériau magnétique doux de l'élément magnétique doux (2) se compensent de façon à ce qu'il en résulte un rapport essentiellement linéaire entre la distance et l'impédance.

10. Dispositif selon la revendication 9, **caractérisé en ce que** le champ magnétique est généré par un aimant, un aimant permanent et/ou un électroaimant, l'objet mesuré pouvant se déplacer par rapport au matériau magnétique doux, le champ magnétique pouvant être modifié à l'endroit du matériau magnétique par le déplacement de l'objet mesuré, l'impédance pouvant varier en fonction du champ magnétique et donc de la distance, du fait du déplacement de l'objet mesuré.

11. Dispositif selon la revendication 9 ou 10, **caractérisé en ce que** le matériau magnétique doux est un matériau amorphe, nanocristallin ou cristallin et/ou un film oblong ou une bande ou un fil est utilisé et/ou un fil avec isolation en verre est utilisé.

12. Dispositif selon l'une des revendications 9 à 11, **caractérisé en ce que** l'alimentation a lieu avec du courant alternatif ou une tension alternative et/ou une alimentation supplémentaire en courant continu est prévue, afin de régler la zone de travail et/ou une alimentation supplémentaire en courant continu est prévue, afin d'effectuer une mesure et une compensation de la température.

13. Dispositif selon l'une des revendications 9 à 12, **caractérisé en ce que** l'aimant peut être approché de différents côtés, de préférence en direction ou parallèlement à l'axe du fil ou transversalement par rapport à celui-ci.

14. Dispositif selon l'une des revendications 9 à 13, **caractérisé en ce que** la variation de l'impédance est mesurée avec une bobine de test à différentes positions et/ou
la bobine de test est alimentée en courant continu pour le réglage de la zone de travail et/ou
une boucle conductrice est utilisée.

15. Dispositif selon l'une des revendications 9 à 14, **caractérisé en ce qu'**une juxtaposition d'éléments individuels agrandit la zone de mesure.

**Fig. 1a**

**Fig. 1b**

**Fig. 2**

**Induktivität und Phase
in Abhängigkeit von H in axialer Richtung**

**Fig. 3**

**Fig. 4**

**Fig. 5**

**Fig. 6**

**Fig. 7**

**Fig. 8a**

**Fig. 8b**

**Fig. 9**

**Fig. 10**

**Fig. 11**

**Fig. 12a**

**Fig. 12b**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19621886 A1
- DE 102007062862 A1
- US 5801630 A
- US 5583333 A
- DE 60003067 T2

**In der Beschreibung aufgeführte Nicht-Patentliteratur**

- **R. VALENZUELA.** *A position sensor based on mag-netoimpedance*